Europäisches Patentamt

European Patent Office

Office européen des brevets

(19)

(11) Publication number: 0 280 356
A2

# (12) EUROPEAN PATENT APPLICATION

(21) Application number: 88200245.4

(51) Int. Cl.⁴: H03F 1/32

(22) Date of filing: 11.02.88

(30) Priority: 26.02.87 IT 1949787

(43) Date of publication of application:
31.08.88 Bulletin 88/35

(84) Designated Contracting States:
BE CH DE ES FR GB GR IT LI NL SE

(71) Applicant: SIEMENS TELECOMUNICAZIONI
S.P.A.
S.S. 11 Padana Superiore Km. 158
I-20060 Cassina De'"Pecchi (Milano)(IT)

(72) Inventor: Buoli, Carlo
Via Di Dietro 21
I-41037 Mirandola(Modena)(IT)
Inventor: Palermo, Nicolangelo
Via Valeggio 55/6
I-33100 Udine(IT)

(74) Representative: Mittler, Enrico et al
c/o Marchi & Mittler s.r.l. Viale Lombardia, 20
I-20131 Milano(IT)

(54) Linearizer for microwave power amplifiers.

(57) The linearizer comprises a main radio frequency or intermediate frequency network (1) and a secondary baseband frequency network (2). The main network (1) comprises a directional coupler (3), a delay line (4), a phase modulator (5) and an amplitude modulator (6). The secondary network (2) comprises means (7, 8) for amplitude sensing and filtering the input signal and a pair of adjustable-gain amplifiers (9, 10) which receive the sensed signal and on the basis of the gain adjustment act on the two modulators (5, 6) in such a manner as to give them nonlinear response curves so as to compensate for the nonlinearity of the power amplifier placed downstream from the linearizer.

Fig.1

## "Linearizer for microwave power amplifiers"

The present invention relates to a linearizer for microwave power amplifiers.

Modulation systems presently in use in radio links (phase and amplitude modulation etc.) impose very stringent linearity requirement for the radio frequency power amplifier of the transmitter on which depends to no small degree the degradation of the modulated signal.

The nominal power of the signal supplied by the final amplifying devices must be considerably lower than the saturation power thereof so that the nonlinearity distorsions due to compression of gain (AM/AM curve) at high powers and to the amplitude modulation-to-phase modulation conversion (AM/PM), again at high powers, meet the specifications of the transmitter. This involves oversizing said amplifying devices and high cost of the power amplifying section.

As is known the use of a linearizing network in the transmitting section, for equal distorsions produced, permits the employment of devices of lower saturation power with a resulting increase in performance, e.g. for applications in transmitters for repeaters on satellites or, for equal saturation power of the final devices, higher amplifier linearity, e.g. for applications in transmitters for earth stations.

A presently well known linearization technique is termed 'feed forward error control' and comprises all the linearizers using an auxiliary microwave amplifier which amplifies an error signal obtained by the difference between the input signal and the distorted signal appropriately attenuated at the output of the main amplifier. The error signal is proportionate to the distorsions generated by the main amplifiers so that added again with appropriate phase and amplitude at the output of the main amplifier it reduces the distorsions with which the output signal is affected.

It is clear that the merit figure or degree of quality of this linearization system depends almost entirely on the balancing of the final adder or coupler, which subtracts the error signal from the output signal of the amplifier. An amplitude and phase balancing adjustment circuitry of considerably complexity is therefore necessary for said coupler. In addition this is a true amplifier-linearizer unit in itself, not an ameliorative addition to a known amplifier.

Another present linearization technique calls for employment of predistortion networks, i.e. nonlinear networks, at radio frequency (RF) or intermediate frequency (IF), inserted upstream from the final microwave amplifier, which distort the input signal by means of networks accomplished with passive or active components such as diodes, GaAs Fet, etc. which work in nonlinear condition to produce AM/AM gain curves and AM/PM amplitude-to-phase conversion in a relationship such that the AM/AM curve and the AM/PM conversion of the "predistortion network-amplifier" unit ensures greater linearity to the transmitting section.

The RF predistortion networks, which use semiconductor devices operating at a high power level, require an inherently complex analysis and design phase since the behaviour of their components must be described in nonlinear network terms. Consequently their development can be critical and their performance unflexible.

The predistortion networks accomplished in IF in addition to the difficulties they display in the analysis and design phase, due to the semiconductor devices used in a nonlinear state, also require new adjustment each time a different amplifier has to be installed on the transmitter.

In view of this state of the art the object of the present invention is to accomplish a linearizer capable of improving the performance of the microwave power amplifiers without the drawbacks of the known systems.

In accordance with the invention said object has been achieved with a linearizer of the predistorsion type applicable upstream from the power amplifier characterized in that it comprises a main network including a phase modulator and an amplitude modulator arranged in cascade and a secondary baseband frequency network including means for amplitude sensing and filtering a part of the input signal so as to produce a sensed signal which is a function of the instantaneous input power and a pair of adjustable gain amplifiers fed with said sensed signal and acting on said modulators so as to give them nonlinear response curves such as to compensate independently for the amplitude nonlinearity and the phase nonlinearity of the power amplifier.

In the linearizer in accordance with the invention the entire main network can be analyzed, designed and tested with simplicity since it includes all circuit blocks which have linear performance versus the transmitted signal. The latter is not distorted by the circuit elements of said blocks but only through the modulating action of the signals applied by the adjustable gain amplifiers.

An important feature of the linearizer in accordance with the invention, which is the main advantage thereof compared with linearizers accomplished by known techniques, lies in the fact that predistorsions to be introduced to compensate for the AM/AM and AM/PM characteristics of the power amplifier to be linearized can be adjusted independently with the aid of a secondary network comprising elements easy to accomplish and operating at baseband frequeny.

Another important feature of the linearizer in accordance with the invention is the fact that the main network can be accomplished with few elements either in the case of a radio frequency input signal or in the case of an intermediate frequency input signal, thus assuring in both cases a high degree of reliability and low cost.

It is clear that the linearizer in accordance with the invention can be placed at the input of the power amplifier, thus processing an RF signal and becoming an integral part thereof. In this manner testing of the linearizer-amplifier unit is an operation in itself. Installation or replacement of the linearized amplfier thus does not involve adjustments of other sections of the transmitter, contrary to IF predistortion networks where testing must necessarily be done with the entire system operating.

An example of a practical embodiment of the linearizer in accordance with the invention is illustrated for greater clarity in the annexed drawings wherein:-

FIG. 1 shows a block diagram of the linearizer in accordance with the invention,

FIGS. 2 and 3 show the typical response curves of the linearizer of FIG. 1,

FIG. 4 shows the characteristic curves of a power amplifier, and

FIG. 5 shows as an example the circuit of a possible adjustable-gain amplifier usable in the linearizer of FIG 1.

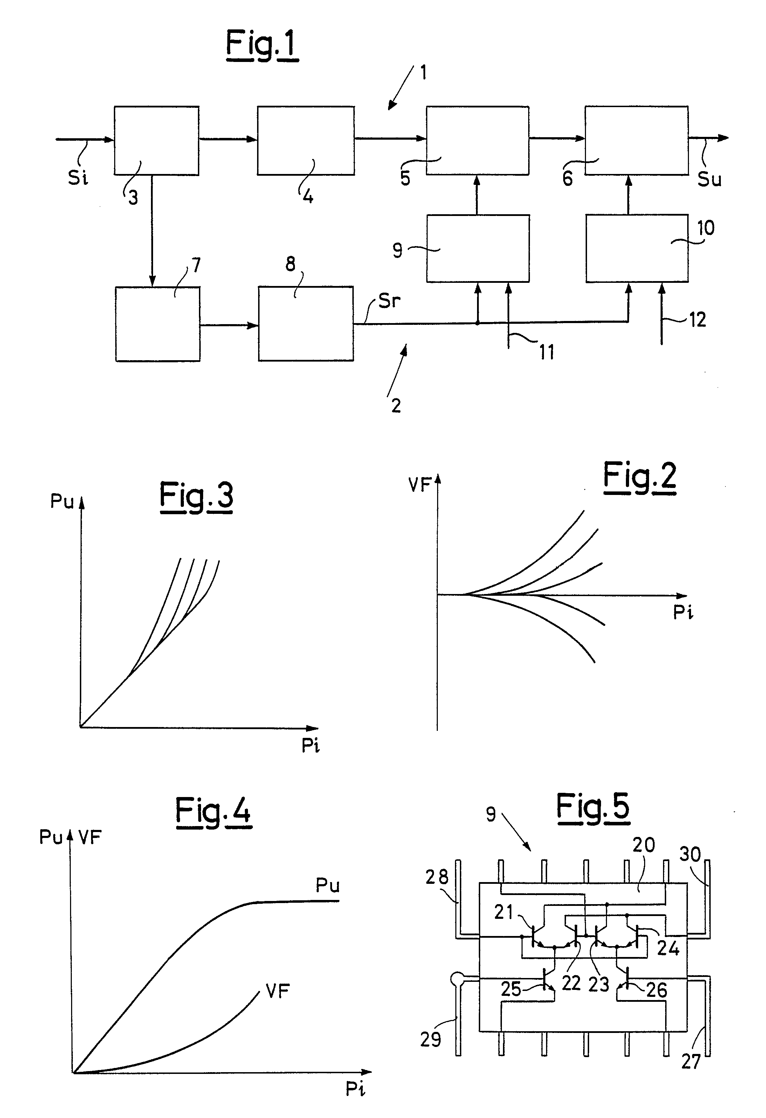

The linearizer of FIG. 1 consists of a main radio frequency network 1 and a secondary network 2 which branches from the first at a directional coupler 3 to which is applied a radio frequency input signal Si to be transmitted.

The main radio frequency network 1 comprises a delay line 4, a phase modulator 5 and an amplitude modulator 6. A modulated radio frequency signal Su constituting the input signal of the power amplifier to be transmitted is made available at the output.

The secondary network 2 comprises an amplitude sensor 7 followed by a filter 8 at the output of which there is a sensed signal Sr which is a function of the instantaneous power of the input signal Si.

Said sensed signal Sr is amplified by two amplifiers 9 and 10 the gain of which is adjustable by means of respective control signals 11 and 12.

The outputs of the amplifiers 9 and 10 are applied to the modulators 5 and 6 respectively in themselves linear networks as concerns the radio frequency transit signal so as to give them nonlinear response curves varying with the gain control signals 11 and 12.

Considering that a power amplifier typically has the response curves of FIG. 4 representing the behaviour of the output power Pu versus the input power Pi (AM/AM curve) with both powers expressed on a logarithmic scale (dBm) and the behaviour of the phase variation VF (expressed in degrees) between the input and the output of the amplifier versus said input power Pi (AM/PM curve) respectively, the control signals 11 and 12 and hence the gains of the amplifiers 9 and 10 are selected in such a manner as to give the modulators 5 and 6 nonlinear response curves independently of each other to compensate for the phase and amplitude nonlinearity of the power amplifier. Typical response curves of the modulators 5 and 6 and hence of the linearizer of FIG. 1 are those illustrated in FIGS. 2 and 3 respectively which show the variability of said curves with the control signals 11 and 12.

FIG. 2 shows that it is possible to reverse through the control signal 11 the sign of the gain of the amplifier 9. In this manner it is possible to obtain either advanced or delayed phase modulation. This permits linearization of power amplifiers with AM/PM either positive (advance) or negative (delay).

The two amplifiers 9 and 10 have a sufficiently wide band so as to not introduce phase and amplitude linearity distorsions in the band of the sensed signal Sr and are easy to accomplish since they work on baseband.

The delay line 4 permits recovery in the main network 1 of the delay introduced by the elements making up the secondary network 2.

As the control signals 11 and 12 permit direct adjustment of the AM/AM and AM/PM curves they can be obtained from an automatic adjustment system which maximizes the linearity of the power amplifier, e.g. a system of adjustment based on temperature or on variations in long-term performance of the amplifier.

FIG. 5 shows a possible example of a variable gain amplifier usable for the amplifier 9 or the amplifier 10. It consists of an integrated circuit 20 comprising two pairs of opposing transistors 21, 22 and 23, 24 with common emitter and two transistors 25, 26 placed between said common emitter and ground. In operation the pin 27 is kept grounded while the pin 28 receives the sensed signal Sr and the pin 29 receives the control signal 11. The output signal is made available at the pin 30 and its signal depends on the voltage difference between the pins 29 and 27.

It is clearly possible to include in one or both of the above baseband frequency amplifiers nonlinear adjustable circuitry elements so as to compensate with better approximation for the distorsion characteristics of the power amplifier.

## Claims

1. Linearizer for microwave power amplifiers characterized in that it comprises a main network (1) including a phase modulator (5) and an amplitude modulator (6) arranged in cascade and a secondary baseband frequency network (2) including means (7, 8) for amplitude sensing and filtering a part of the input signal so as to produce a sensed signal which is a function of the instantaneous input power and a pair of adjustable-gain amplifiers (9, 10) fed with said sensed signal and acting on said modulators (5, 6) so as to give them nonlinear response curves such as to compensate independently for the amplitude nonlinearity and the phase nonlinearity of the power amplifier.

2. Linearizer in accordance with claim 1 characterized in that said amplifiers (9, 10) call for control signals (11, 12) for adjustment of the gain of said amplifiers (9, 10).

3. Linearizer in accordance with claim 1 characterized in that said amplifiers (9, 10) include nonlinear circuit elements.

4. Linearizer in accordance with claim 1 characterized in that said main network (1) is at radio frequency.

5. Linearizer in accordance with claim 4 characterized in that said modulators (5, 6) are circuit blocks which have linear performance versus the radio frequency signal.

6. Linearizer in accordance with claim 1 characterized in that said main network (1) is at intermediate frequency.

7. Linearizer in accordance with claim 6 characterized in that said modulators (5, 6) are circuit blocks which have linear performance versus the intermediate frequency signal.

8. Linearizer in accordance with claim 1 characterized in that said main network (1) includes at least one delay line (4) placed upstream from said modulators (5, 6).

Fig.1

Fig.3

Fig.2

Fig.4

Fig.5